# EUROPÄISCHE PATENTSCHRIFT

(11) **EP 2 323 843 B1**
(45) Veröffentlichungstag und Bekanntmachung des Hinweises auf die Patenterteilung: **24.09.2014**
(21) Anmeldenummer: 09777662.9
(22) Anmeldetag: 05.08.2009
(51) Int. Cl.: B32B 17/10, B32B 27/02, B32B 27/06, B32B 27/08, B32B 27/12, B32B 27/28, B32B 27/30, B32B 27/36, B32B 27/40, D03D 1/00, D06P 5/00, D06P 5/12, H01L 31/02, D03D 9/00, D06M 11/83

(54) **FLÄCHENSTÜCK**
SURFACE PORTION
PIÈCE PLATE

(30) Priorität: 05.08.2008 DE 102008036383; 26.08.2008 DE 102008039709; 05.11.2008 DE 102008055973
(43) Veröffentlichungstag der Anmeldung: 25.05.2011
(73) Patentinhaber: Sefar AG, 9140 Heiden (CH)
(72) Erfinder: SEIDLER, Rouven, CH-9104 Waldstatt (CH); CHABRECEK, Peter, 9306 Freidorf (CH)
(74) Vertreter: Wagner, Kilian
(86) Internationale Anmeldenummer: PCT/EP2009/005659
(87) Internationale Veröffentlichungsnummer: WO 2010/015391

(56) Entgegenhaltungen:
- WO-A-00/04105
- JP-A- 2007 211 353
- US-A- 2 630 620
- US-A- 4 230 763
- US-A- 6 004 649
- US-A- 6 090 473
- US-A1- 2006 057 332

## Beschreibung

Die vorliegende Erfindung betrifft ein Flächenstück aus sich kreuzenden Fäden aus Kunststofffilamenten als gewebte Gewebebahn nach dem Oberbegriff der Ansprüche 1 bis 3.

Eine derartige Vorrichtung ist aus dem Stand der Technik allgemein bekannt und etwa in Form der DE 10 2004 060 105 A1 der Anmelderin als selbstklebendes Drucksubstrat aus gelochten Folien und Papieren offenbart. Eine derartige Gewebebahn ist auf der Frontseite weiß und auf der Rückseite schwarz ausgebildet; ein Auftrag eines Druckmusters oder dergleichen erfolgt auf der weißen Seite. Wird dieses Drucksubstrat an einer Fensterscheibe oder an einem entsprechenden transparenten Flächen-Trägerelement montiert, ist damit die Bedruckung von außen flächig sichtbar, von innen kann der Betrachter jedoch durch die schwarze Fläche nach außen blicken; für ihn bleibt das auf der weißen Flächenseite vorhandene Druckmuster unsichtbar. Eine derartige Vorgehensweise ermöglicht besonders vorteilhaft etwa das Ausgestalten größerer Werbeflächen, die einerseits von innen her transparent sein, andererseits Sonnen- und Sichtschutz gewähren sollen. Auch besitzt die schwarze Rückenfläche den Vorteil, dass der Blick eines Betrachters auf Vorgänge auf der anderen Flächenseite (eine hellere Außenumgebung vorausgesetzt) konzentriert wird.

Gleichzeitig hat sich in der Praxis des Einsatzes derartiger Gewebe herausgestellt, dass insbesondere unter Gesichtspunkten einer Licht- (Sonnen-) Reflexion an einer Außenseite, typischer Anwendungsfall im Architektur- bzw. Gebäudebereich, hier nach wie vor Verbesserungsbedarf besteht, da insbesondere Lichtreflexion einfallenden Lichts (und damit eine gewünschte Abschattung eines Innenraums) noch weiter zu verbessern ist, was jedoch durch die bekannte außenseitige weiße Einfärbung nur bis zu einer gewissen Grenze gewährleistet werden kann.

Aus der US 2006/0057332 A1 ist ein Zaun bekannt, umfassend ein metallisch beschichtetes Gewebe, das am Trägerposten durch Verschrauben fixiert ist.

Aus der US 4,230,763 ist ein Gewebe bekannt, das im Wesentlichen Beschattungszwecken dient. Die Beschattungsvorrichtung umfasst eine Folie mit darauf vorgesehener Metallisierung, die eine Dickenerstreckung zwischen 10Å und 141Å aufweist und somit kaum wahrnehmbar ist.

Auch aus der JP 2007211353 A ist eine Beschattungsanordnung umfassend ein metallisch beschichtetes Gewebe bekannt.

Aufgabe der vorliegenden Erfindung ist es daher, ein gattungsgemäßes Flächenstück mit einer Gewebebahn im Hinblick auf Lichttransmissionseigenschaften, Eignung insbesondere zur großflächigen Verkleidung architektonischer Objekte oder dergleichen, sowie ergänzende visuelle und ästhetische Effekte zu verbessern. Das Flächenstück soll modulartig gestaltet und für Architekturzwecken einsetzbar sein.

Die Aufgabe wird durch das Flächenstück mit den Merkmalen der unabhängigen Ansprüche gelöst; vorteilhafte Weiterbildungen der Erfindung sind in den Unteransprüchen beschrieben.

In erfindungsgemäß vorteilhafter Weise liegt eine Kunststofffilament-Gewebebahn vor, welche (lediglich) einseitig mit einer Metallisierung versehen ist, während die zweite Oberfläche als (vorteilhaft und weiterbildungsgemäß schwarz eingefärbtes) Kunststofffilament verbleibt.

Eine so ausgebildete Gewebebahn, bei einem Anteil von Netzzwischenräumen als offene Flächen im Bereich zwischen 15 und 80 % der Gesamtfläche der Gewebebahn, bietet damit beste Voraussetzungen für architektonische und gestalterische Freiheiten: Einerseits bietet nach wie vor die (bevorzugt schwarze) Kunststoff-Oberfläche als einem Innenraum zugewandte Seite einen nahezu störungsfreien, blendsicheren Ausblick in den Außenraum, die metallisierte Außenfläche dagegen gestattet größtmögliche Gestaltungsfreiheit als attraktive metallische Außenfläche, die zudem, falls gewünscht, in einfacher Weise und unter Nutzung eines metallischen Grundierungseffekts weiterbildungsgemäß bedruckbar ist. Auch hat sich die Metallisierung als besonders günstig gegenüber einfallenden Sonnenstrahlen oder dergleichen Umgebungslicht erwiesen, und ein erfindungsgemäß vorteilhafter einseitiger Auftrag eines Metalls wie etwa A!, Cu, Cr, Ti, Au, AlCu oder weiteren geeignet etwa sputter- oder aufdampf-fähigen Metallen eignet sich herausragend für eine preisgünstige, gleichwohl zuverlässige und qualitativ hochwertige Oberflächengestaltung.

Für die Metallisierung hat sich eine Auftragsdicke im Bereich zwischen 50 und 200 nm, insbesondere im Bereich zwischen 60 und 120 nm, als Metallisierungsschichtdicke auf einer Fiber (einem Kunststofffilament) als besonders bevorzugt herausgestellt, wobei weiterbildungsgemäß die Metallisierung auch mehrschichtig, etwa in Form einer unterliegenden ersten Metallschicht (günstig eignet sich beispielsweise hierfür Al) mit darauf aufgebrachter zweiter Metallschicht (etwa Au, Cu, AlCu oder dergleichen) erfolgen kann. Hier lassen sich geeignete gewünschte optische Wirkungen erzielen, auch ist auf diese Weise eine besonders günstige Haftung und/oder Stabilisierung der äußersten sichtbaren Schicht erreichbar.

Für die Gewebebahn mit dem erfindungsgemäß angegebenen Anteil offener Fläche eignet sich insbesondere eine Gewebedicke im Bereich zwischen 100 und 400 µm, weiter bevorzugt zwischen 140 und 260 µm, wobei sich bevorzugt herausgestellt hat, dass eine tendenziell eher dünnere Gewebebahn, also im Bereich von etwa 140 µm, besonders günstige optische Wirkungen auch realisiert, wenn diese dünne Gewebedicke in Kombination mit sehr offenem Gewebe (also im Bereich von etwa 70 %) auftritt.

In der erfindungsgemäßen Weiterbildung hat es sich als besonders bevorzugt herausgestellt, die Gewebebahn des Flächenstücks zusammen mit transparenten oder teiltransparenten Trägermaterialien, wie etwa Glas- oder Kunststoffplatten, zu verwenden, um so in besonders geeigneter Weise und im Rahmen der Erfindung modulartige, besonders für Architektur- oder Bauzwecke geeignete Flächenstücke zu erzeugen.

Hierzu ist es gemäß einer ersten Erfindungsvariante günstig, eine einseitig metallisierte Gewebebahn mittels einer zwischenliegenden folienartigen Kunststoffschicht an einer Glas- oder Kunststoffplatte zu befestigen, wobei weiter bevorzugt dieses Ausführungsbeispiel doppelt - sandwichartig so realisiert ist, dass beidseits der mittigen Gewebebahn jeweils eine der Kunststofffolien und dann jeweils eine der Glas- bzw. Kunststoffplatten folgt. Bei vorteilhafter Auswahl der Folie als etwa PVB (alternativ PVA, EVA, TPU o. ä.) mit einer günstigen Dicke im Bereich zwischen 0,2 und 2 mm, bevorzugt zwischen 0,38 und 0,76 mm, lässt sich so nach Autoklavieren bzw. Vakuumbehandeln zum Vermeiden des Auftretens von schädlichen Luftblasen oder dergleichen ein Laminat erzeugen, welches in besonders eleganter Weise vorteilhafte optische und architektonische Eignung mit hoher Bruchsicherheit kombiniert (wobei weiterbildungsmäßig hier insbesondere auch als Plattenmaterial Verbund- bzw. Sicherheitsglas benutzt werden kann).

Eine zweite, alternative Variante der Erfindung zum Erzeugen modulartiger Flächenstücke sieht vor, dass die Gewebebahn zwischen zwei Glasschichten randseitig eingespannt ist, wobei diese Ausführungsform günstig und vorteilhaft vorsieht, dass ein entstehender Hohlraum zwischen den Glasschichten bzw. der einseitig metallisierten Gewebebahn ein Vakuum aufweist, alternativ eine Schutz- und/oder Edelgasbefüllung.

Eine dritte Variante der Erfindung zum Erzielen modulartiger Flächenstücke, günstig wiederum für Architektur- oder Bauzwecke, jedoch nicht beschränkt auf dieses Anwendungsgebiet, sieht vor, dass die Gewebebahn unmittelbar zwischen Kunststoffplatten eingelegt wird, wobei eine nachfolgende Wärmebehandlung der Kunststoffplatten dann ein entsprechendes Erweichen bzw. Anschmelzen derselben und ein mechanisches Verbinden mit der Gewebebahn erzeugt, wiederum mit den vorbeschriebenen vorteilhaften Wirkungen.

Die vorliegende Erfindung bietet beliebige Möglichkeiten, dekorative Oberflächenschichten zu erzeugen. Dabei ist es einerseits von der Erfindung umfasst, die Metallisierung als dekorative Oberflächenschicht selbst zu benutzen, insoweit ist der Begriff "Druckmuster" auch als Metallisierung zu verstehen. Alternativ bietet die Metallisierung selbst wiederum eine hervorragende Grundierung für eine darauf aufzutragende Druck-Nutzschicht, etwa mittels Sublimations- oder Digitaldruck. Nicht nur eignet sich die Metallisierung günstig als Haftsubstrat, auch ist eine optisch attraktive Hinterleuchtung bzw. Glanz-Umrandung für einen aufzubringenden zusätzlichen Druck eines Druckmusters realisierbar, insbesondere, wenn dieses zusätzliche Druckmuster (etwa bezogen auf die Querschnittsform einer metallisierten Fiber) randseitig einen unbedruckten metallisierten Bereich belässt.

Im Ergebnis entsteht durch die vorliegende Erfindung ein attraktives, leicht zu verarbeitendes und hochgradig flexibles Flächenstück, welches herausragende optische Eigenschaften mit bestmöglicher Eignung etwa für den Bau-, Fassaden- und/oder Architekturbereich kombiniert, da vorteilhaft und weiterbildungsgemäß vorgesehene Möglichkeiten zur Einbettung der Gewebebahn in entsprechende Trägerstrukturen ein Optimum an Schutz und Witterungsbeständigkeit, auch über langjährige Standzeiten, ermöglicht.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine schematische Draufsicht auf eine einseitig metallisierte Gewebebahn zur Realisierung einer ersten Ausführungsform der vorliegenden Erfindung;
- Fig. 2:: einen Längsschnitt durch eine Anordnung aus einer beidseits von einer Kunststoff-Folienschicht sowie einer Glasplatte begleiteten Gewebebahn als Laminatanordnung;
- Fig. 3:: einen Längsschnitt durch eine Isolierglasanordnung mit einer einseitig metallisierten Gewebebahn, eingespannt zwischen zwei Glasschichten;
- Fig. 4:: als dritte Ausführungsform eine Realisierung eines Verbundmaterials aus (einseitig metallisierter) Gewebebahn zwischen zwei Kunststoffmaterialien im miteinander mechanisch verbundenen Zustand und
- Fig. 5:: eine Detailansicht eines zusätzlich auf der Metallisierung aufgebrachten Druckmusters, isoliert betrachtet für eine Einzelfiber.

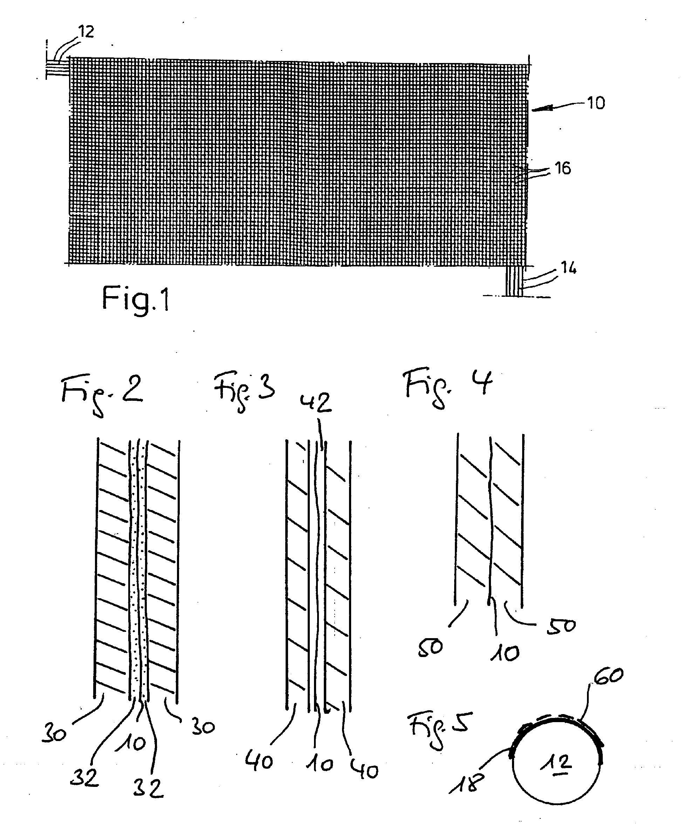

Die Fig. 1 zeigt eine Gewebebahn 10, welche netzartig aus sich kreuzenden Pu-Fäden 12, 14 gewebt ist, wobei die Fädennetze Zwischenräume 16 in etwa quadratischer Form begrenzen. Die Zwischenräume bilden als offene Fläche etwa 40 % der Gesamtfläche.

Die Fäden 12, 14 sind Kunststofffilamente eines monofilen Synthetikgewebes, dessen eine Oberfläche einseitig mit einer Metallisierung (hier: Aluminium einer Schichtdicke von ca. 80 nm) bedampft ist.

Die Fig. 2 zeigt in der Längsschnittansicht, wie die Gewebebahn 10 der Fig. 1 in der Art eines Doppellaminats eingebracht ist zwischen ein Paar von Glasplatten 30 (typische Dicke jeweils ca. 7 mm), wobei zwischen den jeweiligen Glasplatten 30 und der mittigen Gewebebahn 10 jeweils eine dünne Folie 32 aus Polyvinylbutyral (PVB) eingebracht ist. Die Anordnung ist durch Autoklavieren im Vakuum (für eine Vermeidung nachteiliger Luftblasen) so behandelt, dass eine feste, unlösbare Verbundanordnung entsteht, welche sich mit ihrer metallischen Außenseite und ihrer sichtbaren Gewebeinnenseite aus schwarzem Kunststoffgewebe herausragend für eine Vielzahl von Bau- und/oder Architekturanwendungen eignet, insbesondere dadurch, dass auf die in Fig. 2 gezeigte Weise Einzelmodule entstehen, welche als Flächenstücke bzw. Platten einfach verbaubar sind.

Die Fig. 3 zeigt eine Variante zur Realisierung von derartigen Modulen: Hier ist die Gewebebahn 10 der Fig. 1 eingespannt zwischen zwei Glasschichten 40, wobei die Einspannung randseitig erfolgt. Ein sich bildender Hohlraum 42 ist mit einem Schutzgas gefüllt. Auch diese Anordnung eignet sich für die beschriebenen Bau- oder Architekturzwecke (und ist darüber hinaus in ihrer Anwendungsbreite nahezu unbegrenzt).

Schließlich zeigt die Fig. 4 als Ausführungsbeispiel eine Anordnung, bei welcher die Gewebebahn 10 der Fig. 1 unmittelbar eingelegt ist zwischen ein Paar von Kunststoffplatten 50; diese Anordnung wurde erwärmt, so dass das Polymermaterial der Kunststoffplatten 50 in die Zwischenräume der Gewebebahn eindringt und so eine mechanisch stabile, dauerhafte Verbindung entsteht.

Sämtliche der gezeigten Varianten ermöglichen zudem, dass auf die Metallisierung 18 (Fig. 1) ein Druckmuster aufgetragen werden kann; dies kann in ansonsten üblicher Weise geschehen durch Techniken wie Sublimations- oder Digitaldruck. Besonders wirkungsvoll wird ein derartiges Druckmuster in Verbindung mit der Metallisierung, wenn eine Ausgestaltung des Druckmusters durch einen entsprechenden Druckvorgang so erfolgt, dass, wie in der Detailbetrachtung der Fig. 5 verdeutlicht, der Effekt entsteht, dass die Metallisierung 18 auf der gezeigten Fiber 12 randseitig unter der Bedruckung 60 herausragt, mit anderen Worten, die Bedruckung lediglich einen Teilbereich der Metallisierung, jedoch bezogen auf eine jeweilige hälftige Fiberbeschichtung, erfasst. Auf diese Weise erhält die Bedruckung, welche in ansonsten bekannter Weise vielfarbig sein kann, einen attraktiven und gestalterische Freiräume ermöglichenden metallischen Effekt.

Während die vorliegende Erfindung vor allem im Zusammenhang mit modulartig gestalteten Flächenstücken für Architekturzwecke oder dergleichen beschrieben wurde, ist die Erfindung hierauf nicht beschränkt. Vielmehr erstreckt sich die vorliegende Erfindung prinzipiell auf beliebige Flächenstücke, bei welchen ein Kunststoffgewebe mit vorteilhaften optischen Eigenschaften eine einseitige Metallisierung erfährt.

## Patentansprüche

1. Flächenstück aus sich kreuzenden Fäden (12, 14) aus Kunststofffilamenten, das als gewebte Gewebebahn (10) mit zwei einander gegenüberliegenden Oberflächen sowie mit darin gebildeten Durchbrüchen (16) ausgestattet ist, wobei die Gewebebahn eine einseitig als Oberflächenschicht aufgebrachte Metallisierung, die eine Dicke im Bereich zwischen 50 und 200 nm, insbesondere zwischen 60 und 120 nm, aufweist
**dadurch gekennzeichnet, dass**
zwischen 15 und 80 %, insbesondere zwischen 20 und 70 %, der Gewebebahn als offene Fläche in Form von Netzzwischenräumen (16) ausgebildet sind, und dass die gewebte Gewebebahn auf beiden Oberflächen mit einer jeweils zwischenliegenden folienartigen Kunststoffschicht an einer Glas- oder Kunststoffplatte befestigt ist.

2. Flächenstück aus sich kreuzenden Fäden (12, 14) aus Kunststofffilamenten, das als gewebte Gewebebahn (10) mit zwei einander gegenüberliegenden Oberflächen sowie mit darin gebildeten Durchbrüchen (16) ausgestattet ist, wobei die Gewebebahn eine einseitig als Oberflächenschicht aufgebrachte Metallisierung, die eine Dicke im Bereich zwischen 50 und 200 nm, insbesondere zwischen 60 und 120 nm, aufweist
**dadurch gekennzeichnet, dass**
zwischen 15 und 80 %, insbesondere zwischen 20 und 70 %, der Gewebebahn als offene Fläche in Form von Netzzwischenräumen (16) ausgebildet sind, und dass die gewebte Gewebebahn (10) zwischen zwei Glasschichten randseitig eingespannt ist, wobei ein Hohlraum zwischen den Glasschichten ein Vakuum oder eine Schutz- und/oder E-delgasbefüllung aufweist.

3. Flächenstück aus sich kreuzenden Fäden (12, 14) aus Kunststofffilamenten, das als gewebte Gewebebahn (10) mit zwei einander gegenüberliegenden Oberflächen sowie mit darin gebildeten Durchbrüchen (16) ausgestattet ist, wobei die Gewebebahn eine einseitig als Oberflächenschicht aufgebrachte Metallisierung die eine Dicke im Bereich zwischen 50 und 200 nm, insbesondere zwischen 60 und 120 nm, aufweist
**dadurch gekennzeichnet, dass**
zwischen 15 und 80 %, insbesondere zwischen 20 und 70 %, der Gewebebahn als offene Fläche in Form von Netzzwischenräumen (16) ausgebildet sind, und dass die gewebte Gewebebahn zwischen ein Paar von Kunststoffplatten eingelegt ist, deren Kunststoffmaterial so ausgewählt ist, dass ein mechanisches Verbinden mit der Gewebebahn als Reaktion auf eine thermische Behandlung der Schichtanordnung aus Kunststoffplatten und zwischenliegender Gewebebahn erfolgt.

4. Flächenstück nach einem der vorhergehenden Ansprüche, **dadurch gekennzeichnet, dass** die Oberflächenschicht ein Metall aufweist, welches aus der Gruppe bestehend aus Au, Cu, Ti, Cr, Al, AlCu und/oder Legierungen von diesen ausgewählt ist.

5. Flächenstück nach einem der vorhergehenden Ansprüche, **dadurch gekennzeichnet, dass** die einseitig aufgebrachte Oberflächenschicht eine erste unterliegende Metallschicht sowie eine zweite, darauf aufgebrachte Metallschicht aufweist.

6. Flächenstück nach Anspruch 5, **dadurch gekennzeichnet, dass** die erste unterliegende Metallschicht Al aufweist und/oder die zweite darauf aufgebrachte Metallschicht Au, AlCu oder Cu aufweist.

7. Flächenstück nach einem der vorhergehenden Ansprüche, **dadurch gekennzeichnet, dass** die Kunststofffilamente ein Monofilament aufweisen, insbesondere aus Pu oder ein Polyester, und/oder schwarz eingefärbt sind.

8. Flächenstück nach einem der vorhergehenden Ansprüche, **dadurch gekennzeichnet, dass** die einseitig metallisierte Gewebebahn eine Dicke im Bereich zwischen 100 und 400 µm, insbesondere zwischen 140 und 260 µm, aufweist.

9. Flächenstück nach Anspruch 1 sowie nach einem der Ansprüche 4 bis 8 soweit auf Anspruch 1 rückbezogen, **dadurch gekennzeichnet, dass** die folienartige Kunststoffschicht ein Folienmaterial aufweist, welches aus der Gruppe bestehend aus PVB, PVA, EVA, TPU ausgewählt ist und/oder dass in einem unverarbeiteten Zustand eine Dicke im Bereich zwischen 0,2 und 2 mm, insbesondere zwischen 0,38 und 0,76 mm, aufweist.

10. Flächenstück nach einem der vorhergehenden Ansprüche, **dadurch gekennzeichnet, dass** auf der Metallisierung ein Druckmuster aufgebracht ist, insbesondere durch Digital- oder Sublimationsdruck.

## Claims

1. A flat sheet formed by intersecting fibres (12, 14) formed from plastic filaments, provided as a woven length of material (10) having two mutually opposing faces as well as through openings (16) formed therein, wherein the length of material comprises a metallization applied to one face as a surface layer with a thickness in the range 50 to 200 nm, in particular in the range 60 to 120 nm,
**characterized in that**
in the range 15% to 80%, in particular in the range 20% to 70% of the surface of the length of material is open in the form of mesh interstices (16), and **in that** both faces of the woven length of material are attached to a glass or plastic panel by means of a respective intermediate film-like plastic layer.

2. A flat sheet formed by intersecting fibres (12, 14) formed from plastic filaments, provided as a woven length of material (10) having two mutually opposing faces as well as through openings (16) formed therein, wherein the length of material comprises a metallization applied to one face as a surface layer with a thickness in the range 50 to 200 nm, in particular in the range 60 to 120 nm,
**characterized in that**
in the range 15% to 80%, in particular in the range 20% to 70% of the surface of the length of material is open in the form of mesh interstices (16), and **in that** the woven length of material (10) is clamped by its edges between two layers of glass, wherein a gap between the layers of glass is under vacuum or is filled with a protective and/or noble gas.

3. A flat sheet formed by intersecting fibres (12, 14) formed from plastic filaments, provided as a woven length of material (10) having two mutually opposing faces as well as through openings (16) formed therein, wherein the length of material comprises a metallization applied to one face as a surface layer with a thickness in the range 50 to 200 nm, in particular in the range 60 to 120 nm,
**characterized in that**
in the range 15% to 80%, in particular in the range 20% to 70% of the surface of the length of material is open in the form of mesh interstices (16), and **in that** the woven length of material is inserted between a pair of plastic panels the plastic material of which is selected so that mechanical bonding with the length of material occurs as a reaction to heat treating the layered structure of plastic panels and interposed length of material.

4. The flat sheet as claimed in one of the preceding claims, **characterized in that** the surface layer comprises a metal which is selected from the group consisting of Au, Cu, Ti, Cr, Al, AlCu and/or alloys thereof.

5. The flat sheet as claimed in one of the preceding claims, **characterized in that** the surface layer applied to one face comprises a first underlying metallic layer as well as a second metallic layer applied over it.

6. The flat sheet as claimed in claim 5, **characterized in that** the first underlying metallic layer comprises Al and/or the second metallic layer applied over it comprises Au, AlCu or Cu.

7. The flat sheet as claimed in one of the preceding claims, **characterized in that** the plastic filaments comprise a monofilament, in particular formed from PU or a polyester, and/or are coloured black.

8. The flat sheet as claimed in one of the preceding claims, **characterized in that** the thickness of the length of material which is metallized on one face is in the range 100 to 400 µm, in particular in the range 140 to 260 µm.

9. The flat sheet as claimed in claim 1 or as claimed in one of claims 4 to 8 insofar as they append to claim 1, **characterized in that** the film-like plastic layer comprises a film material which is selected from the group consisting of PVB, PVA, EVA and TPU and/or **in that** its thickness in its unprocessed state is in the range 0.2 to 2 mm, in particular in the range 0.38 to 0.76 mm.

10. The flat sheet as claimed in one of the preceding claims, **characterized in that** a printed design is applied to the metallization, in particular by digital or sublimation printing.

## Revendications

1. Pièce plate équipée de fils croisés (12, 14) formés de filaments synthétiques, qui, en tant que nappe de tissu tissée (10), est munie de deux surfaces opposées l'une à l'autre et d'ajours (16) formés dans celles-ci, la nappe de tissu présentant une métallisation appliquée d'un côté en tant que couche supérieure, qui présente une épaisseur dans une plage comprise entre 50 et 200 nm, en particulier entre 60 et 120 nm, **caractérisée en ce qu'**entre 15 et 80 %, en particulier entre 20 et 70 %, de la nappe de tissu sont réalisés sous forme de face ouverte en forme de vides intermédiaires de filet (16) et **en ce que** la nappe de tissu tissée est fixée sur les deux surfaces avec une couche synthétique de type film intermédiaire respective sur une plaque en verre ou synthétique.

2. Pièce plate équipée de fils croisés (12, 14) formés de filaments synthétiques, qui, en tant que nappe de tissu tissée (10), est munie de deux surfaces opposées l'une à l'autre et d'ajours (16) formés dans celles-ci, la nappe de tissu présentant une métallisation appliquée d'un côté en tant que couche supérieure, qui présente une épaisseur dans une plage comprise entre 50 et 200 nm, en particulier entre 60 et 120 nm, **caractérisée en ce qu'**entre 15 et 80 %, en particulier entre 20 et 70 %, de la nappe de tissu sont réalisés sous forme de face ouverte en forme de vides intermédiaires de filet (16) et **en ce que** la nappe de tissu tissée (10) est serrée du côté du bord entre deux couches de verre, une cavité entre les couches de verre présentant un vide ou un remplissage de gaz de protection et/ou de gaz rare.

3. Pièce plate équipée de fils croisés (12, 14) formés de filaments synthétiques, qui, en tant que nappe de tissu tissée (10), est munie de deux surfaces opposées l'une à l'autre et d'ajours (16) formés dans celles-ci, la nappe de tissu présentant une métallisation appliquée d'un côté en tant que couche supérieure, qui présente une épaisseur dans une plage comprise entre 50 et 200 nm, en particulier entre 60 et 120 nm, **caractérisée en ce qu'**entre 15 et 80 %, en particulier entre 20 et 70 %, de la nappe de tissu sont réalisés sous forme de face ouverte en forme de vides intermédiaires de filet (16) et **en ce que** la nappe de tissu tissée est introduite entre une paire de plaques synthétiques, dont le matériau synthétique est sélectionné de telle sorte qu'une liaison mécanique à la nappe de tissu se produise en réaction à un traitement thermique de l'agencement de couches constitué de plaques synthétiques et de la nappe de tissu intermédiaire.

4. Pièce plate selon l'une quelconque des revendications précédentes, **caractérisée en ce que** la couche de surface présente un métal qui est sélectionné parmi le groupe constitué de Au, Cu, Ti, Cr, Al, AlCu et/ou d'alliages de ceux-ci.

5. Pièce plate selon l'une quelconque des revendications précédentes, **caractérisée en ce que** la couche de surface appliquée d'un côté présente une première couche métallique sous-jacente ainsi qu'une deuxième couche métallique appliquée sur celle-ci.

6. Pièce plate selon la revendication 5, **caractérisée en ce que** la première couche métallique sous-jacente présente de l'Al et/ou la deuxième couche métallique appliquée sur celle-ci présente de l'Au, AlCu ou Cu.

7. Pièce plate selon l'une quelconque des revendications précédentes, **caractérisée en ce que** les filaments synthétiques présentent un monofilament, en particulier constitué de Pu ou d'un polyester, et/ou sont teints en noir.

8. Pièce plate selon l'une quelconque des revendications précédentes, **caractérisée en ce que** la nappe de tissu métallisée d'un côté présente une épaisseur dans la plage comprise entre 100 et 400 µm, en particulier entre 140 et 260 µm.

9. Pièce plate selon la revendication 1 et selon l'une quelconque des revendications 4 à 8, dans la mesure où elle se rapporte à la revendication 1, **caractérisée en ce que** la couche synthétique de type film présente un matériau en film qui est choisi parmi le groupe constitué de PVB, PVA, EVA, TPU et/ou qui, dans un état non traité, présente une épaisseur dans la plage comprise entre 0,2 et 2 mm, en particulier entre 0,38 et 0,76 mm.

10. Pièce plate selon l'une quelconque des revendications précédentes, **caractérisée en ce que** l'on applique sur la métallisation un motif d'impression, en particulier par impression numérique ou par impression par sublimation.
